**Europäisches Patentamt**

**European Patent Office**

**Office européen des brevets**

(19)

(11) Veröffentlichungsnummer: **0 170 853**
**A1**

## (12) EUROPÄISCHE PATENTANMELDUNG

(21) Anmeldenummer: **85107841.0**

(22) Anmeldetag: **25.06.85**

(51) Int. Cl.⁴: **G 06 F 1/00**

(30) Priorität: **06.07.84 DE 3425020**

(43) Veröffentlichungstag der Anmeldung: **12.02.86**
**Patentblatt 86/7**

(84) Benannte Vertragsstaaten: **AT BE CH DE FR GB IT LI NL SE**

(71) Anmelder: **Siemens Aktiengesellschaft, Berlin und München Wittelsbacherplatz 2, D-8000 München 2 (DE)**

(72) Erfinder: **Voigt, Ulrich, Dipl.-Ing., Unertlstrasse 31, D-8000 München 40 (DE)**

(54) **Elektrische Baueinheit.**

(57) Die Erfindung bezieht sich auf eine elektrische Baueinheit, die aus mehreren, untereinander in funktioneller Wechselwirkung stehender, gedruckter Leiterplatten besteht. Häufig ist es erforderlich, bei elektrischen Geräten eine Funktionserweiterung durchzuführen. Dazu sieht die Erfindung vor, daß auf der Hauptplatte (1) ein Fußpunktsteckverbinder (2) für Signalbus- und Stromversorgungsanschlüsse vorgesehen ist. Die übrigen, zur Erweiterung dienenden Platten (3) enthalten auf der einen Plattenseite den einen Buchsenteil des kombinierten Steckverbinders (4) und auf der anderen Seite, aber an der gleichen Stelle, den Steckerteil des kombinierten Steckverbinders mit Wanne (5) zur Weiterführung der Bussignal- und Stromversorgungsleitungen. Eine erfindungsgemäße elektrische Baueinheit eignet sich besonders für funktionell erweiterbare EDV- Klein- bzw. Tischgeräte.

EP 0 170 853 A1

0170853

Siemens Aktiengesellschaft
Berlin und München

Unser Zeichen
VPA 84 P 1 4 8 6 E

## Elektrische Baueinheit.

Die Erfindung betrifft eine elektrische Baueinheit, die aus mehreren untereinander in funktionaler Wechselwirkung stehenden gedruckten Leiterplatten besteht.

Zum Beispiel bei Tischgeräten der Datenverarbeitungstechnik ist es häufig erforderlich, eine Funktionserweiterung durchzuführen. Dies geschieht in der Regel dadurch, daß in einem Gehäuse mit Hilfe einer Rückwandverdrahtungsplatte Ersatzplätze zum Einstecken weiterer bestückter Leiterplatten vorgesehen sind. Ein solcher Kartenkäfig weist in der Regel interne Schnittstellenleitungen zu einem gemeinsamen Anschlußfeld auf.

Aufgabe der vorliegenden Erfindung ist es, eine mit gedruckten Leiterplatten in einfacher Weise erweiterungsfähige elektrische Baueinheit zu schaffen.

Zur Lösung dieser Aufgabe wird gemäß der Erfindung die elektrische Baueinheit derart ausgebildet, daß auf der Hauptplatte ein Fußpunktsteckverbinder für Signalbus- und Stromversorgungsanschlüsse vorgesehen ist, daß die übrigen zur Erweiterung dienenden Platten auf der einen Plattenseite den Buchsenteil eines kombinierten Steckverbinders und auf der anderen Seite, aber an der gleichen Stelle den Stiftteil des kombinierten Steckverbinders sowie eine über dieses Teil gestülpte Wanne zur Weiterführung der Bussignal- und Stromversorgungsleitungen enthält.

Durch diese Maßnahmen kann eine eigene Rückwandver-

Zk 1 Fdl/ 2. 7. 1984

0170853

drahtung wegfallen, dadurch entstehen kurze Leitungswege und damit eine Verbesserung der elektrischen
Qualität eines derartig erweiterten Gerätes.

In weiterer Ausbildung ist es möglich, auf der Hauptwie auf den Erweiterungsplatten an einer Breit- oder
Schmalseite in die Platten integrierte Steckverbinderhälften anzuordnen, die das Anschlußfeld für externe
Leitungen bilden.

Dadurch bringt jede einzelne Leiterplatte ihr eigenes
Anschlußfeld mit.

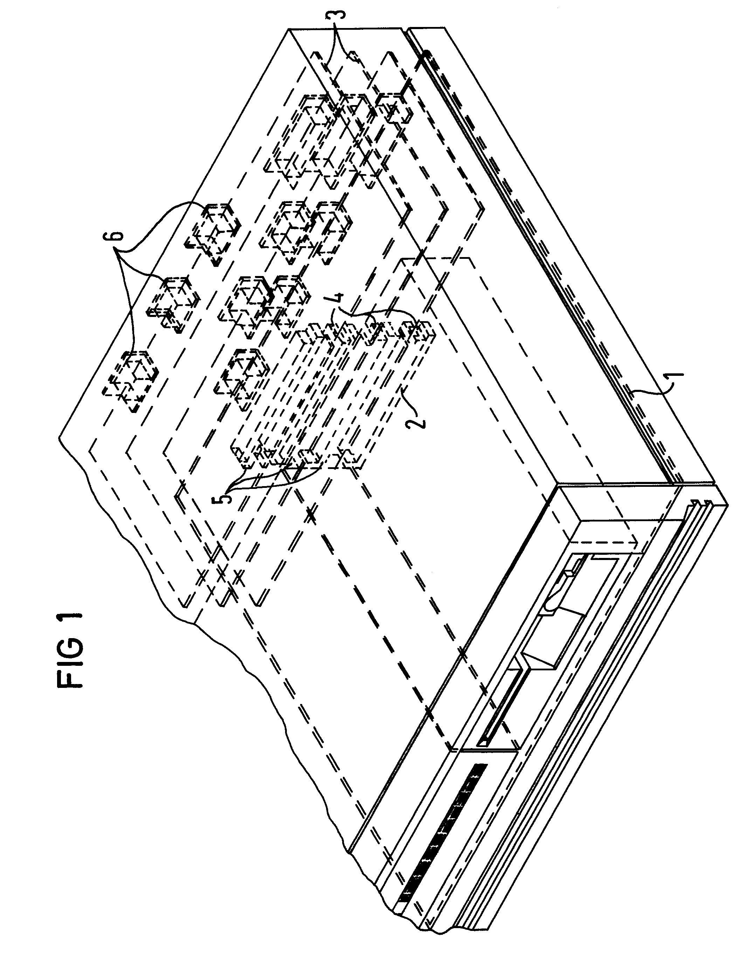

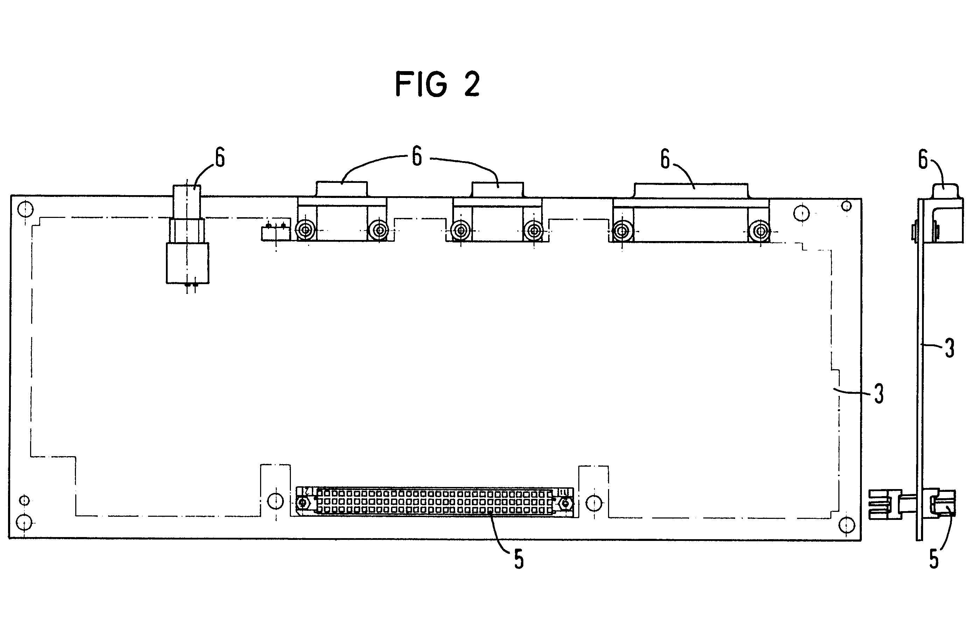

Anhand der FIG 1 und 2 wird die Erfindung näher erläutert.

Es zeigen:
FIG 1 eine perspektivische Darstellung eines Dv-Tischgerätes mit einer Haupt- und drei Erweiterungsplatten,
FIG 2 die konstruktive Ausbildung der Erweiterungsplatten
     im Detail.

In FIG 1 ist schematisch ein EDV-Tischgerät dargestellt.
Ein wesentlicher Teil der elektrischen Funktion dieses
Gerätes wird von Bauteilen übernommen, die auf der Hauptleiterplatte 1 angeordnet sind. Auf der Hauptleiterplatte
1 ist zudem ein Fußpunktsteckverbinder 2 vorgesehen, an
dem sämtliche Bussignal- und Stromversorgungsleitungen
angeschlossen sind. Soll eine Funktionserweiterung eines
derartigen Tischgerätes vorgenommen werden, so kann
dies dadurch geschehen, daß der Reihe nach eine oder
mehrere Erweiterungsplatten 3 auf die Hauptplatte 1 aufgesteckt werden. Die Erweiterungsplatten 3 tragen in
der Regel jedoch an der gleichen Stelle jeweils einen kontaktierten Buchsen- und Stiftkontaktverbinder
- Steckkontaktverbinder 4 -. Dabei sind die Stifte fest
mit den Buchsen zu einem Steckverbinder 4 vereinigt, wobei die Stifte durch die Leiterplatte 3 hindurchragen.
Zum Schutz der Stifte und zur besseren Führung wird
dabei auf der Buchsenseite eine Wanne 5 aufgesetzt, in
die die Stifte der aufgesetzten Leiterplatte 3 hineinragen. Dadurch ist es möglich, beliebig viele Erweiterungsbaugruppen in einfacher Weise stapelförmig übereinander
anzuordnen und die entsprechenden Bussignal- und Stromversorgungsleitungen von einer Platte zur anderen weiterzuführen. Gleichzeitig tragen sowohl die Hauptplatte 1
wie auch die Erweiterungsplatten 3 an der Längsseite
in die Platte integrierte Steckverbinder, die als Anschlüsse für die externen Leitungen bzw. als Trennstellen verwendbar sind. Damit bringt jede der Leiterplatten ihr eigenes Anschlußfeld mit, so daß sich das
Gesamtanschlußfeld der Geräteeinheit aus den dezentralisierten Anschlußfeldem der Leiterplatten zusammensetzt.

Der konstruktive Aufbau einer Erweiterungsplatte 3 ist
in FIG 2 in Draufsicht und Seitenansicht dargestellt. Auf
der einen Längsseite befindet sich der kombinierte, aus
Buchsen- und Steckerstiftverbindern bestehende Steckkontaktverbinder 4. Dabei ist im vorliegenden Fall auf der
Bauteilebestückungsseite der Buchsenkontaktteil des
Steckverbinders 4 und auf der entgegengesetzten Seite
der Stiftkontaktteil des kombinierten Steckverbinders 4
in der Wanne 5 vorgesehen. Auf der gegenüberliegenden
Längsseite sind die in die Platte integrierten Steckverbinder 6 für die externen Leitungen angebracht, wobei es
sich sowohl um Koax- als auch um zweipolige Steckverbinder
handeln kann.

2 FIGUREN
2 Patentansprüche

<u>Patentansprüche</u>

1. Elektrische Baueinheit, die aus mehreren untereinander in funktionaler Wechselwirkung stehenden gedruckten Leiterplatten besteht, d a d u r c h   g e k e n n z e i c h n e t, daß auf der Hauptplatte (1) ein Fußpunktsteckverbinder (2) für Signalbus- und Stromversorgungsanschlüsse vorgesehen ist, daß die übrigen zur Erweiterung dienenden Platten (3) auf der einen Plattenseite den Buchsenteil eines kombinierten Steckverbinders (4) und auf der anderen Seite, aber an der gleichen Stelle, den Stiftteil des kombinierten Steckverbinders (4) sowie eine über dieses Teil geleitete Wanne (5) zur Weiterführung der Bussignal- und Stromversorgungsleitungen enthält.

2. Elektrische Baueinheit nach Anspruch 1, d a d u r c h   g e k e n n z e i c h n e t, daß sowohl auf der Hauptwie auf den Erweiterungsplatten an einer Breit- oder Schmalseite in die Platten integrierte Steckverbinderhälften (6) angeordnet sind, die das Anschlußfeld für externe Leitungen bilden.

FIG 1

0170853

0170853

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ELECTRONIC DESIGN, Band 29, Nr. 16, August 1981, Seiten 193-198, Waseca, MN, US; J. JOHNSON: "Modules ride computer boards for small-scale system expansion" * Seiten 193,196 * | 1 | G 06 F 1/00 |
| Y | IBM TECHNICAL DISCLOSURE BULLETIN, Band 19, Nr. 5, Oktober 1976, Seiten 1835-1836, New York, US; C.J. AUG et al.: "Card-to card connector" * Insgesamt * | 1,2 | |
| Y | US-A-2 977 562 (ACME) * Figur 4 * | 1 | |
| A | DE-A-2 947 793 (HAEFFNER) * Insgesamt * | 1 | RECHERCHIERTE SACHGEBIETE (Int. Cl.4) G 06 F H 05 K H 01 R |
| A | US-A-3 340 439 (AMP) * Spalte 3, Zeilen 40-59; Figuren * | 1 | |
| A | FR-A-2 096 541 (IBM) * Figuren * | 1 | |

--- -/-

Der vorliegende Recherchenbericht wurde für alle Patentansprüche erstellt.

| Recherchenort DEN HAAG | Abschlußdatum der Recherche 14-10-1985 | Prüfer RAMBOER P. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

Europäisches
Patentamt

**EUROPÄISCHER RECHERCHENBERICHT**

0170853
Nummer der Anmeldung

EP 85 10 7841

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | FR-A-1 551 043 (THOMSON-HOUSTON-HOTCHKISS-BRANDT) * Seite 3, rechte Spalte, Absatz 2; figuren * | 1 | |
| A | US-A-4 421 368 (WESTERN) * Figuren * | 1 | |

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 14-10-1985 | Prüfer RAMBOER P. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82